# EUROPEAN PATENT SPECIFICATION

(11) **EP 0 588 630 B1**
(45) Date of publication and mention of the grant of the patent: **06.05.1999**
(21) Application number: 93307305.8
(22) Date of filing: 16.09.1993
(51) Int. Cl.: H03M 9/00, H04J 3/06

(54) **Device for converting data from series to parallel**
Serien-/Parallel-Datenumsetzer
Appareil de conversion de données sérielles en données parallèles

(30) Priority: 16.09.1992 KR 9216841
(43) Date of publication of application: 23.03.1994
(73) Proprietor: GOLDSTAR CO. Ltd., Seoul (KR)
(72) Inventor: Yang, Tae Seok, PO Box 682, Seoul (KR)
(74) Representative: Hitchcock, Esmond Antony

(56) References cited:
- EP-A- 0 096 854
- EP-A- 0 130 899
- EP-A- 0 254 386
- EP-A- 0 473 293
- US-A- 4 525 840

## Description

This invention relates to devices for converting data used in a video cassette recorder (VCR) and the like, more particularly to devices for correct converting of continuously reproduced serial data to original parallel data by detecting a synchronous signal.

In general, magnetic recording devices like a digital VCR process data in parallel. During recording, the parallel data is converted to serial data after provision of synchronous signals. In reproduction, the serial data is converted to parallel data, when the continuously reproduced serial data is required to be converted to parallel data on time in order to obtain the exact original parallel data from the converted serial data. If the converting time is mismatched, the converted parallel data will be different from the original data. For example, if the serial data as converted to parallel data one clock earlier, the least significant bit of the converted data becomes the most significant bit of the next parallel data. Because the matching of converting time is very important as explained above, the synchronous signals provided during recording are detected to use as a basis.

A programmable circuit for series-parallel transformation of a digital signal and its application to a digital video signal receiver is known from US-A-4,573,172. It has a circuit for detecting the synchronizing words in the series digital signal, and a phase comparator generating pulses I and 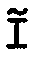 characteristic of the coincidences and non coincidences between the parallel clock signal generated by a programmable divider from the series clock signal and pulses characteristic of the times when synchronizing words are detected. A logic circuit receives the pulses from the phase comparator and transfers them to the sync control input of a programmable divider when a predetermined programmable number of successive non coincidences or coincidences has been detected.

The present invention seeks to provide a device for converting data form series to parallel which is capable of obtaining correct original data through the correct detection of synchronous signals. The device comprises a shift register means for delaying serial data by a number of bits of a synchronous signal pattern in accordance with a serial clock, the serial data being reproduced from a magnetic recording medium; and means for detecting a synchronous signal from an output signal of the shift register means. According to the invention the device also includes a system controller for generating a predetermined bits interval of a parallel load signal and a parallel clock signal from the synchronous signal in accordance with the serial clock;
parallel shift register means for converting the output signal of the shift register means to a predetermined bits interval of parallel data in accordance with the parallel load signal; and
a counter part for counting the parallel clock signal to generate window signals detecting the synchronous signal in a certain period when the detecting means detects the synchronous signal. The detector means may include means for logical operating of the window signals and the synchronous signal detected from the output signal of said shift register means to generating the synchronous signal in the certain period.

In devices according to the invention, the system controller typically includes a first counter for counting the serial clock; means for operating an output signal of said first counter to produce a predetermined bits interval of the parallel clock signal; a first AND gate for operating the detected synchronous signal in the certain period and a first start signal to produce a predetermined bits interval of the parallel load signal, the parallel load signal clearing the first counter; a first delay means for delaying the synchronous signal for a predetermined period of time; and a second delay means for inverting and delaying an output signal of said first delay means to produce a second start signal for operating said counter part. A second AND gate for operating the output signal of said first delay means and the output signal of said counter part to produce a horizontal synchronous signal can also be included. In these embodiments the counter part may be adapted to include a second counter for producing a first window signal to detect the synchronous signal in a period of a first synchronous signal; and a third counter for producing a second window signal to detect the synchronous signal in a period of a second synchronous signal or a subsequent synchronous signal. Such a second counter is suitably operated according to the second start signal and is cleared after counting a predetermined number of clocks. Such a third counter can be operated in the same way.

A conventional device and an embodiment of a device according to the invention will now be described by way of example and with reference to the accompanying drawings wherein:
Figure 1 shows a block diagram of a conventional device for converting data from series to parallel;
Figures 2A, 2B and 2C show patterns of data recorded in a tape, wherein Fig. 2A shows a synchronous block pattern, Fig. 2B shows a recording pattern in a tape, and Fig. 2C shows a pattern of data recorded in a track;
Figure 3 shows a block diagram of a devices for converting data from series to parallel in accordance with the invention.
Figure 4 shows in more detail the system controller of Fig. 3.
Figures 5A to 5F show wave patterns of the input and output of the parts of Fig. 3.

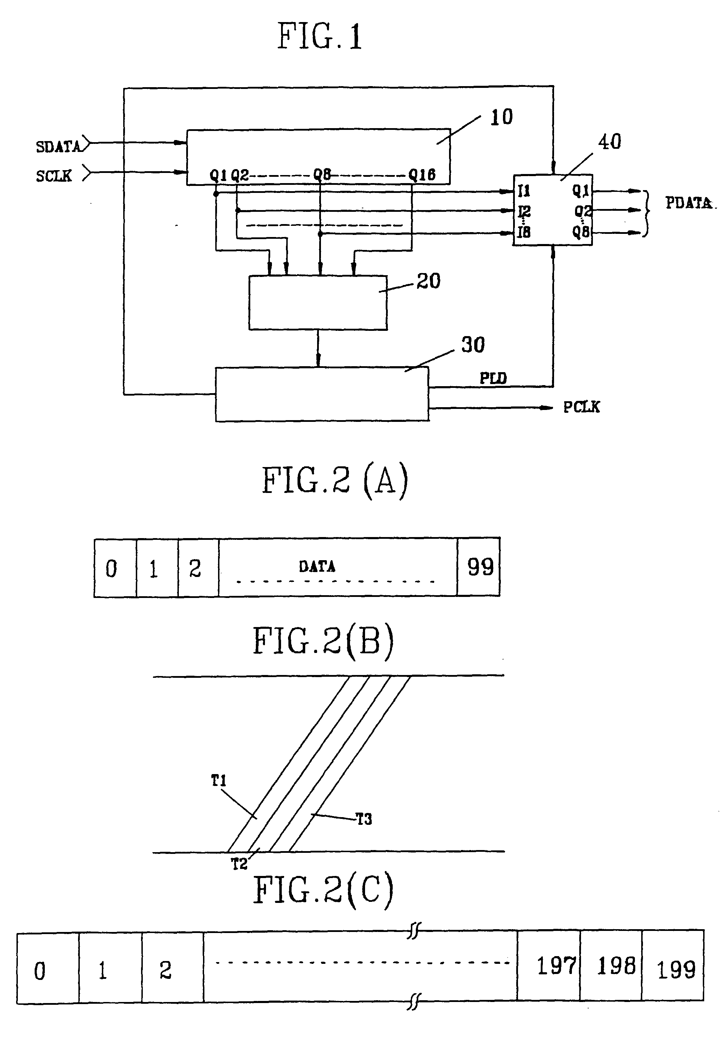

Shown in Figure 1 is a block diagram for a conventional device for converting data from series to parallel. The device includes a shift register 10 for shifting the input serial data as many times as the number of bits of the synchronous signal patterns according to the serial clock, and a synchronous signal detector 20 for detecting synchronous signals from signals by means of a logical combination of output signals of the shift register 10. Also included is a parallel data clock generator 30 for generating base signals which are pulses in an 8-bit interval, and the parallel data clock according to the synchronous signal detected at the synchronous signal detector 20. The parallel shift register 40 converts the output from the shift register 10 to parallel data according to the base signals generated in the parallel data clock generator 30.

The device for converting data from series to parallel shown in Figure 1 employs a 16 bit shift register 10 to detect a 16 bit synchronous signal. In general, when recording data on tape, data is recorded in synchronous block units, and one synchronous block includes 100 8-bits parallel data as shown in Figure 2A, two of which have two synchronous signal patterns (16-bit). While the rest 98 have data patterns.

The 16-bit shift register 10 shifts the serial data reproduced continuously from magnetic tape (not shown) according to the serial data clock. The synchronous signal detector 20 detects the synchronous signal by means of a logical combination of the shifted output Q1 to Q16 of the shift register 10. The parallel data clock generator 30 generates the parallel clock required for processing the parallel data and pulses in 8-bit intervals, by actuating a 3-bit counter (not shown) in the parallel data clock generator 30 according to the detected synchronous signal. The parallel shift register 40 converts the output of the shift register 10 to 8-bit parallel data according to the pulses of the 8-bit interval. The 8-bit parallel data are generated continuously from the first detection of the synchronous signal to the next detection of the signal.

We have found that in some circuits of the type shown in Figure 1, correct signals could not be detected due to damage of the tape, or the deterioration of signals from prolonged use and the instability of the mechanism. For example, burst errors caused by damage of the tape may cause the intervals between synchronous signals to change or the patterns to be disturbed, and random errors may also cause the pattern of the synchronous signal disturbed or other non-synchronous signals to enter as synchronous signals. Typically, as shown in Fig. 2, a tape recording pattern has three tracks; each track T1, T2 and T3 having 200 synchronous blocks recorded thereon for which a few heads in a VCR read in the signal running on each track alternately one by one. However, cases may occur when an error in any synchronous block due to a mechanical error at the moment of the head alternation. This may disturb signal patterns and change the clock. In particular there is a high probability of the starting part and the ending part of the tracks developing an error. Accordingly, in cases when correct synchronous signals cannot be detected, the time to convert data to parallel will be mismatched thereby resulting in the parallel data obtained through this process being different from the original data.

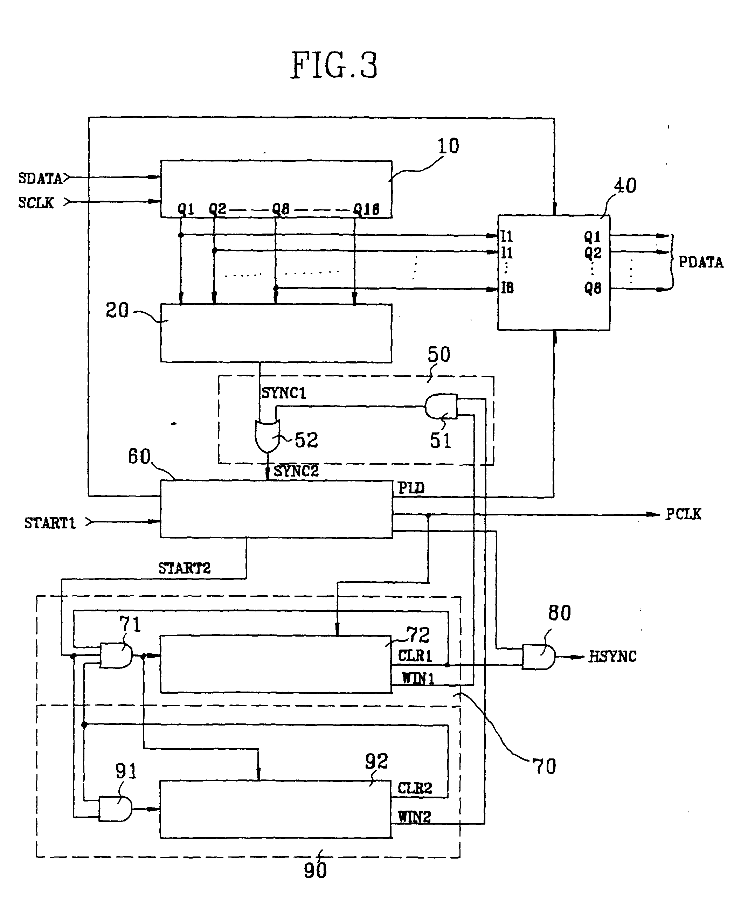

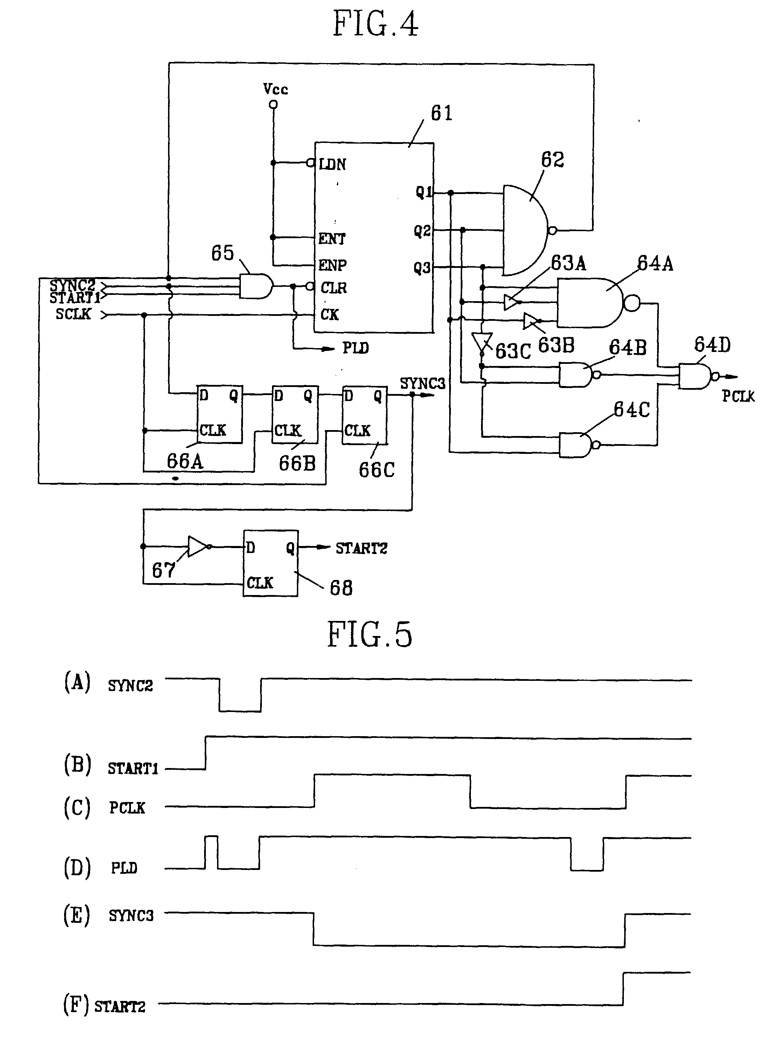

Figure 3 shows a block diagram of a device for converting data from series to parallel in accordance with this invention. Included is a shift register 10 for shifting input serial data SD as may times as the number of bits of synchronous signal patterns, and a synchronous signal detector 20 for detecting the synchronous signal SYNC1 by logical combination of the output of the shift register 10. A detection window controller 50 having AND gate 51 and OR gate 52, controls the generation of synchronous signal SYNC2 for preset intervals by logical operation of the synchronous signal SYNC1 detected in the synchronous signal detector 20 in combination with window signals WIN1 and WIN2, as shown in FIG. 5(A). A system controller 60 controls the generation of parallel load signal PLD as illustrated in FIG. 5(F). A parallel clock signal PCLK is shown in FIG(C); a synchronous signal SYNC3 of parallel time as in FIG. 5(E); and a start signal START2 is shown in FIG. 5(F) according to start signal START1 and synchronous signal SYNC2 as shown in FIG. 5(B). A parallel shift register 40 converts the output data of the shift register 10 to parallel data PDATA according to the parallel load signal PLD of the system controller 60. Also provided is a first counter part 70 having an AND gate 71 and a counter 72, for generating a horizontal clock signal HCLK, window signal WIN1 and clear signal CLR1 in accordance with the parallel clock signal PCLK and the start signal START2 of the system controller 60. An AND gate 80 produced a horizontal synchronous signal HSYNC by the logical product of the synchronous signal SYNC3 of the parallel time of the system controller 60 with the clear signal CLR1 of the first counter 70. In addition second counter 90 has an AND gate 91 and a counter 92, for generating a clear signal CLR2 and detection window signal WIN2, in accordance with the start signal START2 of the controller 60 and the horizontal clock signal HCLK of the first counter 90.

The clear signal CLR1 generates the synchronous signal when the synchronous patterns are disturbed while clear signal CLR2 generates the synchronous signal at the head alternative parts.

As shown in FIG.4, the system controller 60 includes a counter 61 for counting a serial clock signal SCLK, a NAND gate 62 for performing NAND operation of the output Q1, Q2 and Q3 of the counter 61 and generating "0" in 8-bit intervals. Also included are inverters 63A, 63B and 63C, and NAND gates 64A through 64D, for generating the parallel clock signal PCLK as shown in FIG. 5(C) through logical operation of the counter 61 output. An AND gate 65 is also provided for generating the parallel load signal PLD through the logical operation of the NAND gate 62 output, the synchronous signal SYNC2 as shown in FIG.4(A) and the start signal START1 as shown in FIG. 5(B). D flip-flops 66A, 66B and 66C are included for generating the synchronous signal SYNC3 of the parallel time as shown in FIG. 5(E) by shifting the synchronous signal SYNC2 as shown in FIG. 5(A) for preset time. System controller 60 includes inverter 67 and D flip-flop 68 for generating the start signal START2 by inverting and shifting the output signal SYNC3 of the D flip-flop 66C.

The operation and the effect of described devices for converting data from series to parallel in accordance with one embodiment of this invention will be explained hereinafter.

When data is continuously reproduced from a recording tape, the shift register 10 shifts the position of serial data reproduced from the tape to a late position every time the serial clock pulses SCLK are applied and the synchronous signal detector 20 detects the 16-bit synchronous signal SYNC1 from the shifted output Q1 to Q16 of the shift register 10.

The detection window controller 50 controls the synchronous signal SYNC1 to generate the synchronous signal SYNC2 as shown in FIG. 4(A) according to the window signals WIN1 and WIN2 from the counters 70 and 90.

The system controller 60 shown in FIG. 4 controls the counter 61 to change the output Q1, Q2 and Q3 every time the serial clock pulse is applied. This permits the NAND gate 62 to output a low level signal when 7("111") is transmitted from the counter 61. If the synchronous signal SYNC2 transmitted from the OR gate 52 is at a low level as shown in FIG. 5(A) or the counter 61 output becomes 7, the AND gate 65 clears the counter 61 by generating a low level signal when the start signal START1 is maintained at a high level as shown in FIG. 5(B).

The output signal of the AND gate 65 is the parallel load signal PLD as shown in FIG. 5(D). These clear operations are performed in 8-bit intervals. Further, the parallel load signal PLD transmitted from the AND gate 65 is applied to the parallel shift register 40, which, in turn, latches the outputs Q1 to Q8 of the shift register 10 to generate 8-bit parallel data PDATA according to the parallel load signal PLD.

Meanwhile, the inverters 63A, 63B and 63C and the NAND gates 64A to 64D, connected to the output side of the counter 61, generate the parallel clock signal as shown in FIG. 5(C) which is "1" in the case of the counter 61 output Q1, Q2 and Q3 being 1("001"), 2("010"), 3("011") and 4("100") and, "0" in the case of the counter 61 output Q1, Q2, Q3 being 5("101"), 6("110)", 7("111"), 0("000"). For example, if the counter 61 output Q1, Q2, Q3 is "001", the output from the NAND gates 64A, 64B are "1" and the output from the NAND gate 64C is "0", the output from the NAND gate 64D will be "1" and if the counter 61 output Q1, Q2 and Q3 is "101", "1" being the output from NAND gates 64A, 64B and 64C, and "0" being the output from NAND gate 64D.

The D-flip-flop 66A, 66B, 66C generates synchronous signal SYNC3 of the parallel time as shown in FIG. 5(E) according to the output of the synchronous signal SYNC2, the serial clock signal SCLK and the NAND gate 62. This synchronous signal SYNC3 generates a synchronous signal when the synchronous patterns are disturbed.

The synchronous signal SYNC3, after being inverted in the inverter 67, results in the generation of the start signal START2 in the D-flip-flop 68 as shown in FIG. 5(F).

In the first counter 70 in FIG. 3, the AND gate 71 generates the horizontal clock signal HCLK by the logical product of the start signal START2 and the clear signals CLR1, CLR2. Clear signals CLR1 and CLR2 an feedback signals from counters 72 and 92 respectively. Counter 72 generates the clear signal CLR1 in order to generate a synchronous signal at the position where the synchronous signal should exist according to the horizontal clock signal HCLK and the parallel clock signal PCLK of the system controller 60 when the synchronous patterns have been disturbed. Further, the first counter 70 generates detection window signal WIN1 in order to disregard the synchronous detection developed between synchronous signals and transmits the detection window signal WIN1 to one of the input terminals of the AND gate 51 of the detection window controller 50 in order to open detection windows at the two parallel clocks of 99 and 0.

In the second counter 90, the AND gate 91 generates the logical product of the start signal START2 of the system controller 60 and the clear signal CLR2 feedback from the counter 92. Counter 92 generate detection window signal WIN2 and transmits it to the other input terminal of the AND gate 51 in the detection window controller 50 in order to detect initial synchronous patterns correctly, and to help make the next step signal process easier by detecting a preset number of synchronous signal from one track, in spite of the occurrence of errors and/or clock changes at the moment of heads alternation.

Whereas, if virtual data which is not factual data is applied to each of the two synchronous blocks at the start and end of a track, the development of errors at these parts of tracks which have a very high probability of being susceptible to developing an error when the heads alternate, can be avoided.(see FIG. 2(C)).

If it is supposed that the data disturbance happen only at the synchronous blocks of 0 and 199 even on the alternation of the heads, it is still possible to detect a new synchronous signal from the synchronous signal detector by taking the synchronous signal at the third synchronous block as detection windows and as initial clocks for the counter 92, which clear counters 72 and 92 of the value when the counter 92 counts 199.

This synchronous signal become the synchronous signal of the third synchronous block in the next track, thus only 200 synchronous signals can be detected in one track.

As explained above, this invention permits the conversion of serial data to parallel data, if the intervals between synchronous signals are not constant and/or the synchronous patterns are disturbed, to provide synchronous signal at the position where the synchronous signal should exist. Further, at the parts of head alternation, a correct synchronous signal can be detected which allows the original parallel data to be obtained by providing virtual data which permits the detection of synchronous signal through detection windows provided thereby. The device for converting data from series to parallel in accordance with this invention can of course be applicable to all apparatuses which transmit, record and reproduce digital data.

## Claims

1. A device for converting data from series to parallel, comprising:
shift register means (10) for delaying serial data by a number of bits of a synchronous signal pattern in accordance with a serial clock, the serial data being reproduced from a magnetic recording medium;
detector means (20) for detecting a synchronous signal from an output signal of said shift register means (10); characterised in that the device further comprises;
a system controller (60) for generating a predetermined bits interval of a parallel load signal and a parallel clock signal from the synchronous signal in accordance with the serial clock;
parallel shift register (40) means for converting the output signal of said shift register means (10) to a predetermined bits interval of parallel data in accordance with the parallel load signal; and
a counter part (70) for counting the parallel clock signal to generate window signals detecting the synchronous signal in a certain period when said detector means (20) detects the synchronous signal.

2. A device according to Claim 1, wherein the detector means (20) includes means for logical operating of the window signals and the synchronous signal detected from the output signal of said shift register (10) means to generating the synchronous signal in the certain period.

3. A device according to Claim 2 wherein the system controller (60) includes a first counter (61) for counting the serial clock; means (62) for operating an output signal of said first counter to produce a predetermined bits interval of the parallel clock signal; a first AND gate (65) for operating the detected synchronous signal in the certain period and a first start signal to produce a predetermined bits interval of the parallel load signal, a first delay means for delaying the synchronous signal for a predetermined period of time; and a second delay means for inverting and delaying an output signal of said first delay means to produce a second start signal for operating said counter part.

4. A device according to Claim 3, including a second AND gate (80) for operating the output signal of said first delay means and the output signal of said counter part to produce a horizontal synchronous signal.

5. A device according to Claim 3 or Claim 4, wherein the counter part includes a second counter (72) for producing a first window signal to detect the synchronous signal in a period of a first synchronous signal; and a third counter (92) for producing a second window signal to detect the synchronous signal in a period of a second synchronous signal or a subsequent synchronous signal.

6. A device according to Claim 5, wherein the second counter (72) is operated according to the second start signal and is cleared after counting a predetermined number of clock pulses.

7. A device according to Claim 5 or Claim 6, wherein the third counter (92) is operated according to the second start signal is cleared after counting a predetermined number of clock pulses.

## Patentansprüche

1. Vorrichtung zur Konvertierung von seriellen Daten in parallele Daten, mit
einem Schieberegister (10) zur Verzögerung von seriellen Daten einer Anzahl von Bits eines synchronen Signalpakets gemäß einer seriellen Zeitvorgabe, wobei die seriellen Daten von einem magnetischen Aufzeichnungsmedium reproduziert werden;
einem Detektor (20) zur Messung eines Synchronsignals von einem Ausgangssignal des Schieberegisters (10);
gekennzeichnet durch einen Systemregler (60) zur Erzeugung eines vorbestimmten Bitintervalls eines parallelen Eingangssignals und eines parallelen Zeitsignals aus dem Synchronsignal gemäß der seriellen Zeitvorgabe;
einem Parallelschieberegister (40) zur Konvertierung des Ausgangssignals des Schieberegisters (10) in ein vorbestimmtes Bitintervall von parallelen Daten gemäß des parallelen Eingangssignals;
und einem Zähler (70) zum Zählen des parallelen Zeitsignals zur Erzeugung eines Fenstersignals zur Messung des synchronen Signals in einem vorbestimmten Zeitraum, wenn der Detektor (20) das synchrone Signal mißt.

2. Vorrichtung gemäß Anspruch 1, gekennzeichnet durch einen Detektor (20), der Mittel zur logischen Bearbeitung des Fenstersignals und des Synchronsignals umfaßt, die vom Ausgangssignal des Schieberegisters (10) zur Erzeugung des Synchronsignals in dem vorgegebenen Zeitraum gemessen werden.

3. Mittel gemäß Anspruch 2, gekennzeichnet durch den Systemregler (60), mit einem ersten Zähler (61) zur Zählung der seriellen Zeitvorgabe; Schaltungsmittel (62) zum Schalten eines Ausgangssignals des ersten Zählers zur Erzeugung eines vorbestimmten Bitintervalls des parallelen Zeitsignals, einem ersten AND-Gatters (65) zur Schaltung des gemessenen Synchronsignals in einem bestimmten Zeitintervall und einem ersten Startsignal zur Erzeugung eines vorbestimmten Bitintervalls des parallelen LOAD-Signals, einem ersten Verzögerungsmittel zum Verzögern des Synchronsignals um ein vorbestimmtes Zeitintervall und zweite Verzögerungsmittel zur Invertierung und Verzögerung eines Ausgangssignals aus dem ersten Verzögerungsmittel zur Erzeugung eines zweiten Startsignals zur Ansteuerung des Zählers.

4. Vorrichtung gemäß Anspruch 3, gekennzeichnet durch ein zweites AND-Gatter (80) zur Schaltung des Ausgangssignals des ersten Verzögerungsmittels und des Ausgangssignals des Zählers zur Erzeugung eines horizontal synchronen Signals.

5. Vorrichtung gemäß Anspruch 3 oder 4, gekennzeichnet durch einen Zähler mit einem zweiten Zähler (72) zur Erzeugung eines ersten Fenstersignals zur Messung des synchronen Signals in dem Zeitraum eines ersten Synchronsignals und einem dritten Zähler (92) zur Erzeugung eines zweiten Fenstersignals zur Messung des synchronen Signals in einem Zeitraum eines zweiten Synchronsignals oder eines nachrangigen Synchronsignals.

6. Vorrichtung gemäß Anspruch 5, gekennzeichnet durch einen zweiten Zähler, der gemäß dem zweiten Startsignal geschaltet ist und nach dem Zählen einer vorbestimmten Anzahl von Zeitimpulsen rücksetzbar ist.

7. Vorrichtung gemäß Anspruch 5 oder 6, gekennzeichnet durch einen dritten Zähler (92), der gemäß dem zweiten Startsignal geschaltet ist und nach dem Zählen einer vorbestimmten Anzahl von Zeitimpulsen rücksetzbar ist.

## Revendications

1. Dispositif pour convertir les données série en données parallèles, comprenant :
un moyen de registre à décalage (10) pour retarder les données série d'un nombre de bits d'une combinaison de signaux synchrones conformément à une horloge série, les données série étant reproduites à partir d'un support d'enregistrement magnétique;
un moyen détecteur (20) pour détecter un signal synchrone provenant d'un signal de sortie dudit moyen de registre à décalage (10); caractérisé en ce que le dispositif comprend en outre :
un contrôleur de système (60) pour générer un intervalle de bits prédéterminé d'un signal de charge parallèle et d'un signal d'horloge parallèle provenant du signal synchrone conformément à l'horloge série;
un moyen de registre à décalage (40) pour convertir le signal de sortie dudit moyen de registre à décalage (10) en un intervalle de bits prédéterminé de données parallèles conformément au signal de charge parallèle; et
une partie compteur (70) pour compter le signal d'horloge parallèle et générer des signaux de fenêtre détectant le signal synchrone dans une certaine période lorsque ledit moyen détecteur (20) détecte le signal synchrone.

2. Dispositif selon la Revendication 1, dans lequel le moyen détecteur (20) comprend un moyen pour le traitement logique des signaux de fenêtre et du signal synchrone détecté à partir du signal de sortie dudit moyen de registre à décalage (10) pour générer le signal synchrone dans la certaine période.

3. Dispositif selon la Revendication 2 dans lequel le contrôleur de système (60) comprend un premier compteur (61) pour compter le signal d'horloge série; un moyen (62) pour traiter un signal de sortie dudit premier compteur et produire un intervalle de bits prédéterminé du signal d'horloge parallèle; une première porte ET (65) pour traiter le signal synchrone détecté dans la certaine période et un premier signal de démarrage pour produire un intervalle de bits prédéterminé du signal de charge parallèle, un premier moyen de retard pour retarder le signal synchrone pendant une durée prédéterminée; et un deuxième moyen de retard pour inverser et retarder un signal de sortie dudit premier moyen de retard pour produire un deuxième signal de retard et traiter ladite partie compteur.

4. Dispositif selon la Revendication 3, comprenant une deuxième porte ET (80) pour traiter le signal de sortie dudit premier moyen de retard et le signal de sortie de ladite partie compteur et produire un signal synchrone horizontal.

5. Dispositif selon la Revendication 3 ou la Revendication 4, dans lequel la partie compteur comprend un deuxième compteur (72) pour produire un premier signal de fenêtre et détecter le signal synchrone dans une période d'un premier signal synchrone; et un troisième compteur (92) pour produire un deuxième signal de fenêtre et détecter le signal synchrone dans une période d'un deuxième signal synchrone ou d'un signal synchrone suivant.

6. Dispositif selon la Revendication 5, dans lequel le deuxième compteur (72) est traité conformément au deuxième signal de démarrage et est remis à zéro après avoir compté un nombre d'impulsions d'horloge prédéterminé.

7. Dispositif selon la Revendication 5 ou la Revendication 6, dans lequel le troisième compteur (92) est traité conformément au deuxième signal de démarrage et est remis à zéro après avoir compté un nombre d'impulsions d'horloge prédéterminé.
